# EUROPEAN PATENT SPECIFICATION

(11) **EP 0 432 981 B1**
(45) Date of publication and mention of the grant of the patent: **21.04.1999**
(21) Application number: 90313369.2
(22) Date of filing: 10.12.1990
(51) Int. Cl.: G03F 3/10

(54) **Method for transferring an image and apparatus therefor**
Bildübertragungsverfahren und Vorrichtung
Méthode pour le transfert d'une image et appareil

(30) Priority: 11.12.1989 JP 321855/89
(43) Date of publication of application: 19.06.1991
(73) Proprietor: KONICA CORPORATION, Tokyo 163 (JP)
(72) Inventor: Sasa, Nobumasa, Konica Corporation, Hino-shi, Tokyo (JP); Shimizu, Kunio, Konica Corporation, Hino-shi, Tokyo (JP); Watanabe, Manabu, Konica Corporation, Hino-shi, Tokyo (JP)
(74) Representative: Ellis-Jones, Patrick George Armine

(56) References cited:
- EP-A- 0 421 381
- DE-A- 3 800 768
- GB-A- 2 081 180

## Description

### FIELD OF THE INVENTION

The present invention relates to a method and an apparatus for transferring an image such as the image transfer process for making color proofs in color printing.

### BACKGROUND OF THE INVENTION

It is well-known that a color proof (also called color sheet) for color correction is used in order to save the time and labor for galley proof making that takes place as a step prior to the running-on printing in the multicolor printing process.

Since the color proof for color correction is used to estimate the color reproduction of finished prints, color reproducibility of the colour proof must closely resemble that of finished prints.

As a method for preparing multicolor transfer images by using color proofs there is the method described in Japanese Patent Publication Open to Public Inspection (hereinafter referred to as Japanese Patent O.P.I. Publication) No. 28649/1985, in which a transfer medium (image sheet) is superposed on a copying sheet (image-receiving sheet such as art paper) to have an image on the image sheet transferred by heating under pressure onto the image-receiving sheet. Preparation of a color proof in this method is carried out in the manner that e.g., cyan (C), magenta (M), yellow (Y) and black (BK) pigments are used to make the respective colors' image sheets, and the four different color images are separately superposedly transferred onto an image-receiving sheet by repeating the transfer operation four times to thereby form a full color transfer image on the image-receiving sheet. For the image transfer there has conventionally been used a method in which an image sheet and an image-receiving member in contact with each other are passed between pair of juxtaposed rollers (nip rollers).

The image-receiving sheet, however, is usually paper, which is liable to be deformed and has a finely rough surface, so that air tends to be present in the form of fine air bubbles between the image sheet and the image-receiving sheet. For this reason, there are cases where the image transfer is not partially made where it should be or there appear many transfer-failed spots, which make it impossible to provide a complete transfer image. In addition, there is also a case where the image sheet gets creased and fails to provide a good transfer image.

EP-A-0421381, which was published after the filing date of the present application, provides a method of transferring an image from a transferring medium on to a record sheet. The method includes steps of setting a record sheet on a rotatable drum, superimposing a transferring medium in which only an image to be transferred is formed on a support material of a transferring medium on the record sheet, and pressing the transferring medium and the record sheet on to the drum by a pressing roller while rotating the drum so that only the image is transferred to the record sheet. The pressing drum may comprise an iron axis covered with silicone rubber, or may comprise a silicone rubber roller.

GB-A-2081180 discloses a rotary press comprising two parallel rollers, retained in a particular angular relationship. The rollers comprise holding means such as adhesive tape for a sheet on one roller. The press is particularly suited for transfer of colour separation images from carrier sheets to a receptor sheet in a proofing process.

### SUMMARY OF THE INVENTION

It is an object of the present invention to provide an image transfer method and an apparatus for efficiently transferring an image on a transfer medium onto an image-receiving member to form thereon a transferred image having no defects and closely resembling an original image. This object is achieved with the method as set out in claim 1 and the apparatus of claim 5.

### BRIEF DESCRIPTION OF THE DRAWINGS

The drawings relate to the examples of the invention.

Fig.1 is a schematic front view of a principal part of a transfer apparatus.

Fig.2 is a front view of the inside of the transfer apparatus.

Fig.3 is a left side view of the inside of the transfer apparatus.

Fig.4 is a cross-sectional view as seen in the direction of arrows from the line IV-IV of Fig.2.

Figs.5(b), 5(c), 5(d), 5(e) and 5(f) are schematic perspective views showing the steps of preparing an image sheet, and 5(a) is a schematic front view as seen in the condition of 5(b).

### DETAILED DESCRIPTION OF THE INVENTION

The present invention relates to a method for transferring an image from an image transfer medium onto an image receiving member, comprising:
exposing imagewise a colored light-sensitive material comprising a transparent support and provided thereon a colored light-sensitive layer;
developing the exposed material to obtain an image transfer medium having an image;
setting an image receiving member on a silicone rubber layer provided on a rotatable sheet carrying member;
superposing the image transfer medium on the image receiving member; and
pressing the image transfer medium and the image receiving member onto the silicone rubber layer provided on the sheet carrying member by a pressing member while rotating the sheet carrying member, and an apparatus for transferring an image from an image transfer medium, in which an image to be transferred is formed by exposing imagewise a colored light-sensitive material comprising a transparent support and provided thereon a colored light-sensitive layer and developing the exposed material, to an image receiving member, comprising:
   a rotatable sheet carrying member and, provided thereon, an anti-slip silicone rubber layer for loading an image transfer medium and an image receiving member thereon; and
   a means for pressing the image transfer medium and the image receiving member onto the anti-slip silicone rubber layer provided on the sheet carrying member.

The invention is detailed below:

Firstly, an image forming medium (colored light-sensitive film) for preparing an image transfer medium suitable for the invention is described in detail.

The colored light-sensitive material comprises a transparent support having thereon a colored light-sensitive layer for forming an image. In order to facilitate transfer of the image onto an image-receiving medium such as art paper and removal of the support after the transfer, it is preferable to form a releasing layer for giving peelability between the support and the colored light-sensitive layer. In the case of preparing a color proof from a print varnished for making its surface glossy such as a poster, a thermally adhesive layer is provided between the releasing layer and the colored light-sensitive layer, and the thermally adhesive layer or both the releasing layer and the thermally adhesive layer are transfered together with the image, whereby a color proof as glossy as the orginal print can be obtained.

As the transparent support, polyester film such as particularly biaxially stretched polyethylene terephthalate film is suitable in respect of the dimensional stability to water and heat, but acetate film, poly(vinyl chloride) film, polystyrene film, polypropylene film and polyethylene film may also be used.

Since the image on the foregoing image transfer medium is finally transferred onto an image-receiving member, in order to make the transfer onto the image-receiving member sufficiently efficient to facilitate the removal of the support after the transfer, it is preferable to subject the support surface to a mold releasing treatment with an appropriate repellent oily substance on the surface of the support on the side having the colored light-sensitive layer or to provide a releasing layer between the colored light-sensitive layer and the support.

As the repellent oily substance there may be used silicone resin, fluororesin, fluorosurfactant, polyolefin or polyamide.

Since polypropylene film, polyethylene film, etc., are capable of showing a good mold releasability without being subjected to a special treatment therefor, in a preferred embodiment these films may be provided on the foregoing transparent support in the form of a layer thinner than the support.

Most preferably, ethylene-vinyl acetate copolymer resin layer is provided for a releasing layer. In the ethylene-vinyl acetate copolymer resin, the vinyl acetate preferably accounts for 5 to 33% by weight of the whole copolymer resin, and the VICAT softening point of the resin is preferably not higher than 80°C. To the ethylene-vinyl acetate copolymer resin layer, as long as its softening point does not exceed 80°C, may be added various polymers, supercooling substances, surface active agents, mold lubricants.

Methods for providing the ethylene-vinyl acetate copolymer resin on the support include:
1) a method for providing an ethylene-vinyl acetate copolymer resin layer wherein a solution of the ethylene-vinyl acetate dissolved in an organic solvent such as toluene is coated on a support and then dried;
2) a dry laminating method wherein a solution of poly(vinyl acetate), poly(vinyl chloride), epoxy resin, polyurethane resin, natural rubber or synthetic rubber dissolved in an organic solvent is used as an adhesive, the adhesive is coated on a support and then dried in hot air or by heating, and an ethylene-vinyl acetate copolymer resin film is laid on the support and both are pressured with heating for laminating;
3) a hot-melt laminating method wherein a mixture of ethylene-vinyl acetate copolymer, ethylene-acrylate copolymer, polyamide resin, petroleum resin, rosins and waxes is used as an adhesive, the adhesive is heated and kept molten to be coated on a support by a doctor blade coating method, roll coating method, gravure coating method or reverse roll coating method, the coated support is immediately stuck together with an ethylene-vinyl acetate copolymer resin film, and, if necessary, they are once heated to a high temperature and then cooled;
4) an extrusion laminating method wherein ethylene-vinyl acetate copolymer resin is kept molten and extruded by and through an extruder into film, which, while in a molten state, is laminated on the support by application of pressure thereto; and
5) a coextrusion method wherein a plurality of extruders are used to extrude simultaneously both a molten material to form a support film and a molten ethylene-vinyl acetate copolymer resin to form a film to thereby form the ethylene-vinyl acetate copolymer resin film on the support film in a single operation.

Other materials usable for the releasing layer include alcohol-soluble polyamide, alcohol-soluble nylon, a blend of a partially esterified styrene-maleic anhydride copolymer resin with methoxymethylated nylon, poly(vinyl acetate), polyacrylate, polymethacrylate-acrylate copolymer, poly(vinyl chloride), vinyl chloride-vinyl acetate copolymer, poly(vinyl butyrate), cellulose acetate-phthalate, methyl cellulose, ethyl cellulose, cellulose diacetate, cellulose triacetate, poly(vinyl alcohol), butyl cellulose, hydroxyethyl cellulose, carboxymethyl cellulose, cyanoethyl cellulose, cellulose acetate, cellulose acetate-butyrate, hydroxypropylmethylcellulose phthalate, hydroxypropylmethylcellulose hexahydrophthalate, and mixtures thereof.

The thickness of the releasing layer is preferably 0.01 to 100µm, and more preferably 0.1 to 50µm.

The thermally adhesive layer is preferably transparent and nonadhesive at room temperature, and more preferably thermally adhesive at 80 to 160°C.

For the thermally adhesive layer there may be used the following film-forming thermoplastic resins having a softening point of 50 to 110°C: organic copolymers such as olefin (co)polymers, vinyl chloride (co)polymers, vinylidene chloride (co)polymers, vinyl acetate (co)polymers, (meth)acrylate (co)polymers, styrene/(meth)acrylate copolymers, polyesters, vinylbutyral resins, chlorinated rubber, cellulose derivatives, styrene/butadiene copolymers, aliphatic petroleum resins, aromatic petroleum resins, alicyclic petroleum resins, rosin resin, terpene resin and cumarone resin. These may be used alone or in combination, and further in combination with different other resins or plasticizers.

The thickness of the thermally adhesive layer is preferably 1 to 20µm, and more preferably 2 to 10µm.

The colored light-sensitive layer comprising a light-sensitive component is imagewise exposed and processed, whereby the light-received or non-light-received portion thereof is imagewise removed to form a color image.

As the light-sensitive component contained in the colored light-sensitive layer there may be used various compounds which include all compounds such as monomers, prepolymers and polymers, in which, when exposed to an active light, their molecular structures are immediately chemically changed so that their solubilities in solvents are changed - when a certain solvent is applied thereto, the exposed or nonexposed area is dissolved to be removed. Usable examples of the light-sensitive component include photo-crosslinkable resins of which the solubility is reduced when exposed to light, the so-called negative-positive type, such as poly(vinyl alcohol) cinnamic acid esters; mixtures of diazonium salts or condensates thereof with poly(vinyl alcohol), poly(vinyl pyrrolidone), polyacrylamide, etc.; mixtures of aromatic azide compounds as photo-crosslinkable agents with cyclorubbers as binders; and light-sensitive resins which utilizes photo-radical polymerization or photo-ionic polymerization. In addition, there are those of which the solubility in solvent increases when exposed to light, the so-called positive-positive type; for example, light-sensitive resin compositions comprising o-quinonediazide as a light-sensitive substance, such as those condensates of hydroxyl group and/or amino group-containing compounds with 1,2-benzoquinonediazido-4-sulfonyl-chloride, 1,2-naphthoquinonediazido-4-sulfonyl-chloride, 1,2-naphthoquinonediazido-5-sulfonyl-chloride, and 1,2-naphthoquinonediazido-6-sulfonylchloride may be suitably used.

As the above hydroxyl group-containing compound there are, for example, trihydroxybenzophenone, dihydroxyanthraquinone, bisphenol A, phenol novolac resin, resorcinol-benzaldehyde condensate resin, pyrogallol-acetone condensate resin. And as the above amino group-containing compound there are, for example, aniline, p-aminodiphenylamine, p-aminobenzophenone, 4,4'-diaminodiphenylamine, 4,4-diaminobenzophenone.

As the above o-quinone compounds there may also be used those described in J. KOSAR, 'Light-Sensitive System' (Wiley & Sons, New York, 1965) and Inui Matsunaga, 'Kankosei Kobunshi (light-sensitive polymers)' (Kodan-sha, 1977).

Further, as examples of the positive-positive type there may also be used those light-sensitive resin compositions containing i) compounds capable of generating an acid when exposed to an active light; ii) compounds having at least one linkage decomposable by an acid; and iii) novolac resins containing two or three different phenols.

The above light-sensitive component content of the colored light-sensitive layer is preferably 5 to 80% by weight.

The colored light-sensitive layer preferably contains a binder.

Usable as the binder for the colored light-sensitive layer is a high molecular compound having an excellent layer-formability and solubility in a solvent, and preferably capable of being dissolved and swelling in an alkaline developer solution.

Examples of the above high-molecular compound include those containing in the molecular structure thereof a structural unit having an aromatic hydroxyl group represented by the following formula: 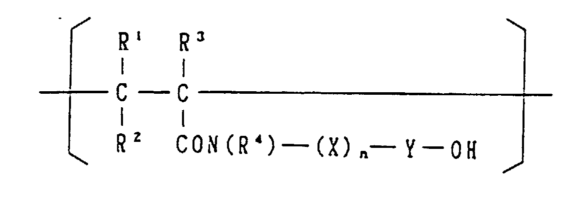 wherein R¹ and R² each represent a hydrogen atom, an alkyl group or a carboxylic acid group; R³ is a hydrogen atom, a halogen atom or an alkyl group; R⁴ is a hydrogen atom, an alkyl group, a phenyl group or an aralkyl group; X is a divalent organic group to link between a nitrogen atom and an aromatic carbon atom; n is an integer of 0 or 1; and Y is a substitutable phenylene group or a substitutable naphthylene group.

Examples of the monomer to constitute the structure unit represented by the above formula include (meth)acrylamide monomers such as N-(4-hydroxyphenyl)-(meth)acrylamide, N-(2-hydroxyphenyl)-(meth)acrylamide and N-(4-hydroxynaphthyl)-(meth)acrylamide; o-, m- or p-hydroxyphenyl-(meth)acrylate monomer; o-, m- or p-hydroxystyrene monomer. Of these the preferred are o-, m- or p-hydroxyphenyl(meth)acrylate monomer and N-(4-hydroxyphenyl)-(meth)acrylamide monomer, and more preferred is the N-(4-hydroxyphenyl)-(meth)acrylamide monomer.

It is preferable to use as the binder a copolymer of one of the following monomers and a monomer for forming the structure having the aromatic hydroxyl group represented by the above formula. 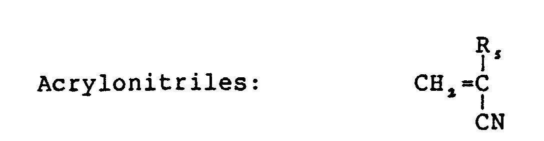 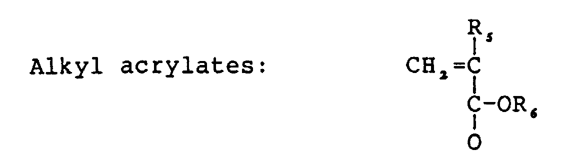 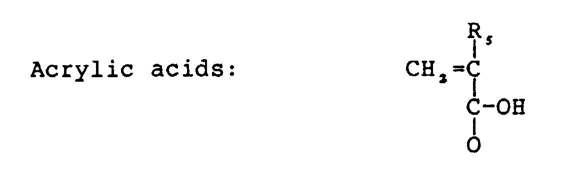 wherein R⁵ is a hydrogen atom, an alkyl group or a halogen atom, and R' is an alkyl group, a phenyl group or a naphthyl group.

The monomer having the aromatic hydroxyl group represented by the above formula accounts for preferably 1 to 30 mole% of the above copolymer.

The unit formed from the above acrylonitrile accounts for preferably 0 to 50 mole% of the above copolymer, and more preferably 5 to 40 mole% to take into account the developability. The structure unit formed from the above alkyl acrylate accounts for preferably 50 to 95 mole% of the copolymer in view of the developability in a weak alkaline aqueous solution, and most preferably 60 to 95 mole% for giving the best developability.

The above high molecular compound may have the above acrylic acid such as acrylic acid or methacrylic acid copolymerized also with the above-mentioned structural unit for the purpose of finely adjusting the developability thereof. The copolymer accounts for preferably 0 to 20 mole% of the high molecular compound, and most preferably 0 to 10 mole% in consideration of the development latitude.

The weight average molecular weight of the above high molecular compound is preferably 1,000 to 100,000, and more preferably 1,000 to 30,000 in view of the developability or resolution when a low alkaline aqueous solution is used as a developer solution. These high molecular compounds can be synthesized in accordance with well-known copolymerization methods.

Examples of the above high molecular compound include those copolymers having the following structural formula: 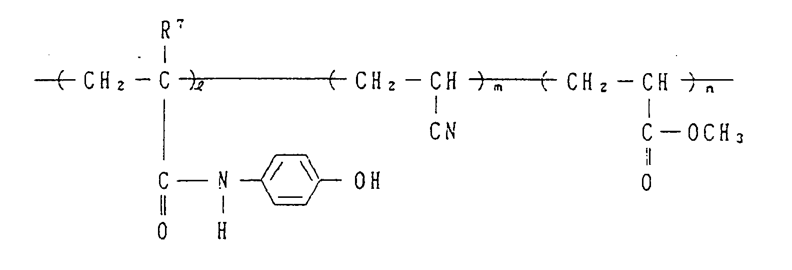 (Weight average molecular weight: 1,000 to 30,000) ℓ:m:n = (1 to 25):(5 to 40):(50 to 95)
wherein R⁷ is a hydrogen atom or a methyl group.

In addition, as the binder there may also be used polycondensate resins such as novolac resins that can be obtained by polycondensation of at least one phenol with an active carbonyl compound.

Also, there may be used those containing high molecular compounds (A) having in the molecular structure thereof a unit derived from a carboxylic acid vinyl ester monomer having the following formula:

RCOOCH=CH₂

wherein R is an alkyl group having 1 to 17 carbon atoms.

Preferred examples of the carboxylic acid vinyl ester monomer for constituting the polymerization unit having the above formula are as follows:
(1) Vinyl acetate

   CH₃COOCH=CH₂
(2) Vinyl propionate

   CH₃CH₂COOCH=CH₂
(3) Vinyl butyrate

   CH₃(CH₂)₂COOCH=CH₂
(4) Vinyl pivalate

   (CH₃)₃CCOOCH=CH₂
(5) Vinyl caproate

   CH₃(CH₂)₄COOCH=CH₂
(6) Vinyl caprylate

   CH₃(CH₂)₆COOCH=CH₂
(7) Vinyl caprate

   CH₃(CH₂)₈COOCH=CH₂
(8) Vinyl laurate

   CH₃(CH₂)₁₀COOCH=CH₂
(9) Vinyl myristate

   CH₃(CH₂)₁₂COOCH=CH₂
(10) Vinyl palmitate

   CH₃(CH₂)₁₄COOCH=CH₂
(11) Vinyl stearate

   CH₃(CH₂)₁₆COOCH=CH₂
(12) Vinyl versatate 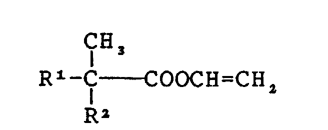
wherein R¹ and R² are alkyl groups of which the total number of carbon atoms is 7; i.e., R¹+R²=C₇H₁₆.

More preferred carboxylic acid vinyl ester monomers are those of which the carboxylic acid's principal chain has 1 to 4 carbon atoms, and the most preferred is vinyl acetate.

The foregoing R includes alkyl groups having a substituent; i.e., the polymerization unit includes vinyl esters of substituted carboxylic acids.

The high molecular compound (A) may be a homopolymer obtained by polymerization of a single kind of carboxylic acid vinyl ester, a copolymer comprised of two or more kinds of carboxylic acid vinyl ester, or a copolymer of a carboxylic acid vinyl ester and different other monomers copolymerizable therewith at an arbitrary ratio.

Preferred as the high molecular compound (A) are those having a unit derived from a vinyl acetate polymerization unit in the molecular structure thereof. More preferred among them are those containing 40 to 95 wt% of a unit derived from vinyl acetate having a number average molecular weight Mn of 1,000 to 100,000 and a weight average molecular weight Mw of 5,000 to 500,000.

The most preferred are those which contain a 40 to 95 wt% of a unit derived from vinyl acetate and a unit derived from a carboxylic acid vinyl ester whose chain is longer than that of vinyl acetate, and which has a number average molecular weight Mn of 2,000 to 60,000 and a weight average molecular weight Mw of 10,000 to 150,000.

In this instance, a monomer that is polymerizable with the vinyl acetate to constitute a vinyl acetate polymerization unit-having high molecular compound is allowed to be any arbitrary one as long as it can form a copolymer; for example, may be selected from among the above exemplified monomers.

The copolymers of the monomer components shown below are examples of the copolymers usable as the high molecular compound (A) of the invention, but the invention is not limited thereto.
(1) Vinyl acetate-ethylene
(2) Vinyl acetate-styrene
(3) Vinyl acetate-crotonic acid
(4) Vinyl acetate-maleic acid
(5) Vinyl acetate-2-ethylhexyl acrylate
(6) Vinyl acetate-di-2-ethylhexyl maleate
(7) Vinyl acetate-methylvinyl ether
(8) Vinyl acetate-vinyl chloride
(9) Vinyl acetate-N-vinyl pyrollidone
(10) Vinyl acetate-vinyl propionate
(11) Vinyl acetate-vinyl pivalate
(12) Vinyl acetate-vinyl versatate
(13) Vinyl acetate-vinyl laurate
(14) Vinyl acetate-vinyl stearate
(15) Vinyl acetate-vinyl versatate-ethylene
(16) Vinyl acetate-vinyl versatate-2-ethylhexyl acrylate
(17) Vinyl acetate-vinyl versatate-vinyl laurate
(18) Vinyl acetate-vinyl versatate-crotonic acid
(19) Vinyl propionate-vinyl versatate
(20) Vinyl propionate-vinyl versatate-crotonic acid
(21) Pivalic acid-vinyl stearate-maleic acid.

To the foregoing colored light-sensitive layers are added coloring agents such as dyes or pigments. The colored light-sensitive material, when used for making a color proof, requires pigments or dyes of yellow, magenta, cyan and black in colors, and in addition, may also use other metallic powders, white pigments, fluorescent pigments. The following are examples of the known pigments and dyes to those skilled in the art, wherein C.I stands for color index.

| | |
|---|---|
| Victoria pure blue | C.I 42595 |
| Auramine | C.I 41000 |
| Cation brilliant flavin | C.I basic 13 |
| Rhodamine 6 GCP | C.I 45160 |
| Rhodamine B | C.I 45170 |
| Safranine OK70:100 | C.I 50240 |
| Erioglycine X | C.I 42080 |
| Fast black HB | C.I 26150 |
| No.1201 Lionol yellow | C.I 21090 |
| Lionol yellow GRO | C.I 21090 |
| Symuler fast yellow 8GF | C.I 21105 |
| Benzidine yellow 4T-564D | C.I 21095 |
| Symuler fast red 4015 | C.I 12355 |
| Lionol red 7B4401 | C.I 15830 |
| Fastgen blue TGR-L | C.I 74160 |
| Lionol blue SM | C.I 26150 |
| Mitsubishi carbon black MA-100 | |
| Mitsubishi carbon black #30, #40, #50 | |
| Cyanine blue 4920, produced by Dainichiseika Co. | |
| Seikafast carmine 1438, | " |
| Seikafast yellow H-7055, 2400, | " |

The coloring agent content of the colored light-sensitive layer is preferably 5 to 50% by weight.

The coloring agent/binder ratio in the colored light-sensitive layer may be determined according to a known method to those skilled in the art, taking into account an objective optical density and the colored light-sensitive layer's removability by a developer; for example, the value is preferably 5 to 75% by weight for dyes, and 5 to 90% by weight for pigments.

The thickness of the colored light-sensitive layer may be determined in accordance with a known method to those skilled in the art in consideration of an intended optical density, the types of coloring agents (dyes, pigments, carbon black) used in the colored light-sensitive layer and the contents thereof, but the colored light-sensitive layer should be as thin as possible within the tolerable range to reproduce a high-quality image having a high resolution. Accordingly, the thickness is normally 0.1 to 5 µm.

To the colored light-sensitive layer may, if necessary, be added a plasticizer, coatability improving agent and the like in addition to the above component materials.

Examples of the plasticizer include various low molecular compounds such as phthalates, triphenyl phosphates, maleates, etc., and examples of the coatability improving agent include nonionic surface active agents such as ethyl cellulose, polyalkylene ether, and fluorosurfactants.

The colored light-sensitive layer may be divided into two layers; one is a coloring agent layer composed of a coloring agent and a binder, and the other a light-sensitive layer composed of a light-sensitive component and a binder. In this instance, either one of the layers may be present on the support side.

The above colored light-sensitive layer may be coated on a support by any one of various coating methods including the roll coating, reverse roll coating, dip coating, air-knife coating, gravure coating, gravure offset coating, hopper coating, blade coating, rod coating, wire-doctor coating, spray coating, curtain coating, and extrusion coating methods.

Drying of the coated layer is conducted by blowing a heated air against the coated surface. The temperature of the heated air is preferably 30 to 200°C, and more preferably 40 to 140°C. A method wherein the heated air's temperature is kept constant to dry the colored light-sensitive layer is prevailing, but the temperature may be raised by stages. The heated air is supplied onto the coated surface at a rate of preferably 0.1 to 30 meters per second, and more preferably 0.5 to 20 meters per second.

Where the colored light-sensitive layer contains a photopolymerizable compound, in order to prevent the oxygen's hindrance to the polymerization, an overcoat layer may be provided on the colored light-sensitive layer. The overcoat layer can be dissolved or can swell in a developer solution. Examples of the resin used for the overcoat layer include poly(vinyl alcohol), poly(ethylene oxide), polyacrylic acid, polyacrylamide, poly(vinylmethyl ether), poly(vinyl pyrrolidone), polyamide, gum arabic, glue, gelatin, casein; celluloses such as viscose, methyl cellulose, ethyl cellulose, hydroxyethyl cellulose, hydroxypropylmethyl cellulose, carboxymethyl cellulose; and starches such as soluble starch and denatured starch.

The above colored light-sensitive film is imagewise exposed in the manner that a color separation screen film is contacted with a colored image-forming material corresponding to each individual color, and the image-forming material is exposed through the screen film to ultraviolet radiation. As the radiation source there may be used a mercury vapor lamp, high pressure mercury vapor lamp, metal-halide lamp, tungsten lamp, xenon lamp, fluorescent lamp.

Subsequently, development is conducted. As a developer solution for use in the formation of a colored image, an alkaline developer solution comprised principally of water as a solvent is preferably used. Examples of the alkali agent used in the developer include inorganic alkali agents such as sodium carbonate, sodium hydrogencarbonate, sodium silicate, potassium silicate, sodium hydroxide, potassium hydroxide, lithium hydroxide, sodium tertiary phosphate, sodium secondary phosphate, potassium tertiary phosphate, potassium secondary phosphate, ammonium tertiary phosphate, ammonium secondary phosphate, sodium metasilicate, sodium bicarbonate, potassium carbonate, ammonium carbonate and ammonium silicate; and organic alkali agents such as mono-, di- and triethanolamines and tetraalkylammonia hydroxide. The alkali agent content of the developer composition is preferably 0.05 to 30% by weight. The above alkaline developer solution may also contain an organic solvent such as ethylene-glycol-monoethyl ether, benzyl alcohol, n-propyl alcohol, a surface active agent, a sulfate, a chelating agent such as EDTA, a deforming agent such as an organic silane compound.

As an image-receiving member onto which is to be transferred a colored image that has been formed by developing the above imagewise exposed colored light-sensitive film, there may be used general printing paper such as art paper, coat paper, fine paper or synthetic paper.

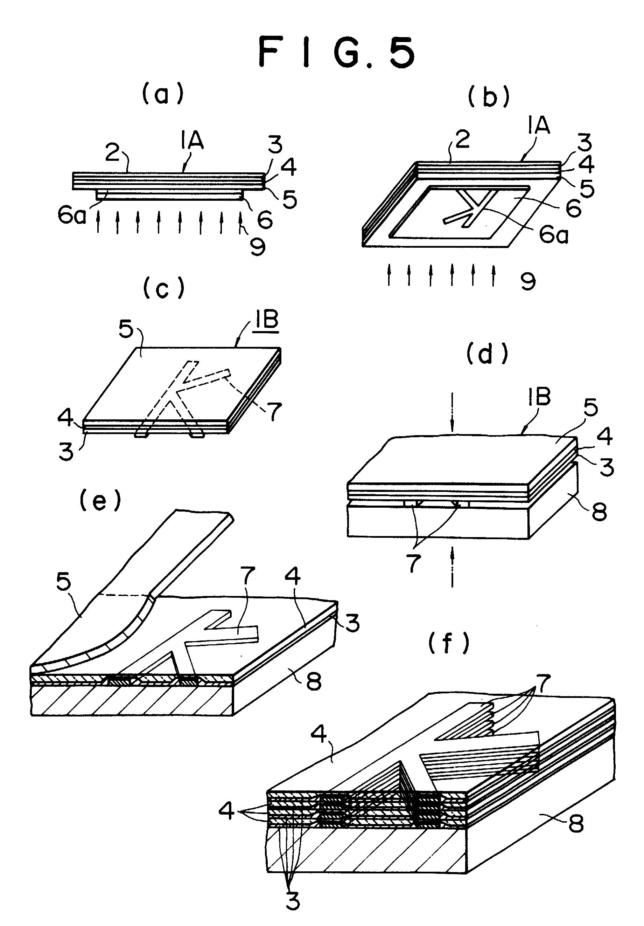

The following are the particular examples of the invention. Fig.5 is a schematic drawing for explaining the procedure of forming a full color image on an image-receiving sheet.

Fig.5(a) is a front view, wherein, as shown in the perspective view of Fig.5(b), a positive film original 5 is brought into contact with the support film 5 side of a colored light-sensitive film 1A, and the film 1A is imagewise exposed to ultraviolet radiation 9 which irradiates from the side of original 6. In the drawing, 2 is a light-sensitive layer, 3 is a thermally adhesive layer, and 4 is a releasing layer.

Next, when the exposed colored light-sensitive film 1A is developed as shown in Fig.5(c), an image 7 corresponding to the image 6a of the original 6 (see Fig.5(a) and (b)) is formed on the support film 5. In the drawing, 1B is the developed colored light-sensitive film (hereinafter called image sheet).

Then, as shown in Fig.5(d), the image sheet 1B with its image 7 facing down is superposed upon an image-receiving member 8, and both sheets are pressed while being heated. In this process, image 7 is made to stick to image-receiving member 8.

When the support film 5 is peeled off from the image-receiving member 8 as shown in Fig.5(e), the image 7 is sealed up in between thermally adhesive layer 3 and releasing layer 4 to remain on the image-receiving sheet 8. The above sealing up is made when the thermally adhesive layer 3 is softened by being heated in the preceding process.

When, in the order of black(BK), yellow(Y), magenta(M) and cyan(C), the respective colors' transfer operations are conducted according to the above procedure, four color patterns are superposed on the image-receiving sheet 8 as shown in Fig.5(f). Fig.5(f) shows four different colors' patterns are superposed on the identical position, but one or two or all of the Y, M, C and BK patters constitute a final color transfer image that is as true as the original.

The transferred image thus obtained is an image 7 which is a true reproduction of the original image 6a and which is made glossy by the colorless, transparent and glossy releasing layer 4.

The procedure of forming an image on the colored light-sensitive film is as follows: When the colored light-sensitive film 1A is exposed through a positive film orginal 6 as an exposure mask to ultraviolet radiation 9 as shown in Fig.5(a) and (b), on the BK, Y, M and C-colored light-sensitive film 1A are formed the respective colors' latent image patterns. When the film is developed, the respective colors' image patterns alone are formed on the support as aforementioned, and the film is then washed and dried, whereby an image sheet 1B shown in Fig. 5 (c) is obtained. The above development is a normal developing process.

Where the thermally adhesive layer 3 is not provided in the colored light-sensitive film 1A, the releasing layer 4 is peeled off together with the support film 5 in the process shown in Fig. 5 (e), and in the process of Fig. 5 (f), the image 7 alone remains on the image-receiving layer 8.

The steps of Fig. 5 (d) to (f) are performed in succession on a rotary drum.

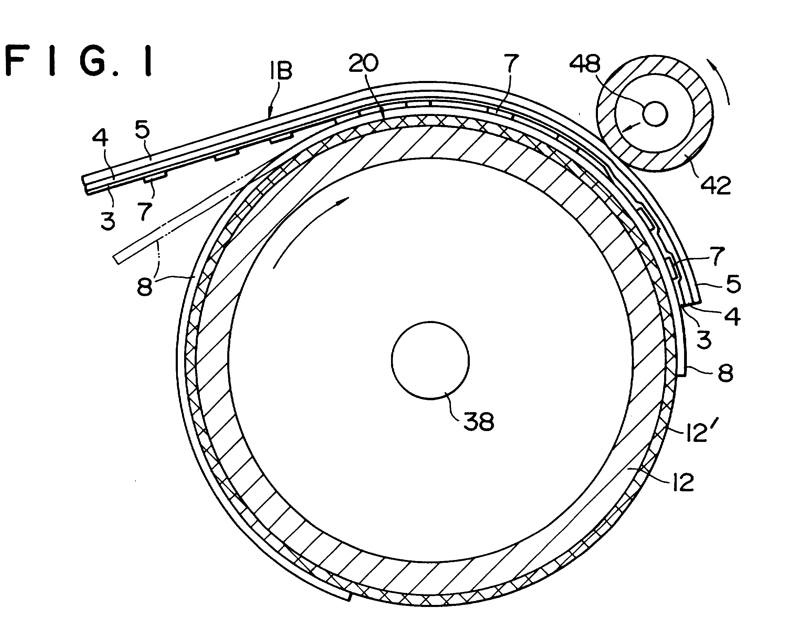

Fig.1 is a schematic drawing showing the procedure of forming a transfer image on an image-receiving member in this manner.

The leading end of an image-receiving paper 8 is fixed on the drum 12, preheated to a specified temperature, and wound around so that its entire paper is carried on the drum 12 by rotating the drum in the drection of arrow for one revolution. Then, the leading end of an image sheet 1B is fixed likewise to be superposed upon the image-receiving paper 8 by rotating the drum in the direction of arrow. A roller 42, preheated to a specified temperature, presses the image sheet 1B against the image-receiving paper 8, and the support film 5 is peeled off from the image sheet 1B at a downstream position beyond the roller 42. When the image-receiving paper 8 comes to its original position after one revolution of the drum 12, the rotation of the drum is stopped to superpose the image sheet upon the subsequent image-receiving paper to be ready for the subsequent color transfer operation. In the above process, the drum 12 and the roller 42 are preheated to 50 to 100°C, and more preferably 70 to 100°C, the pressure of the roller 42 is 1 to 20 kg/cm², and more preferably 2 to 8 kg/cm², and the time required for an image transfer is 30 seconds to 2 minutes per every transfer. This procedure comprising the steps of (d) to (f) of Fig.5 is repeated for colors BK, Y, M and C in the described order to carry out the transfer operation.

An antislip layer 12' is provided on the surface of the drum 12 to prevent an image-receiving paper from slipping as shown in Fig.1. The antislip layer 12' may be either merely placed around the drum 12 or stuck to the drum by using a primer by, e.g., a lamination method. Alternatively, the layer may be formed by coating and drying on the drum a coating liquid prepared by dissolving and dispersing a material containing an antislip layer-forming rubber in a solvent.

The thickness of the antislip layer, in order to conduct heat from the drum side in heating, is not restricted as long as it does not hinder the thermal conductivity of the drum, but is preferably 0.1 to 300µm.

The antislip layer of the invention is a layer which contains a rubber to make the most of its antislip effect. As the rubber, natural rubber and synthetic rubber may be used. The latter is preferable, and silicone rubber is more preferable.

Preferred as the silicone rubber suitable for use in the antislip layer are compounds composed principally of linear organic polysiloxanes having a molecular weight of thousands to hundreds of thousands having the following repetitive units: 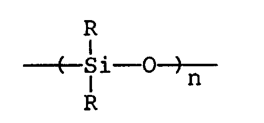 wherein n is an integer or 2 or more, and R is an alkyl group, a halogenated alkyl group, a vinyl group, or an aryl group, each having 1 to 10 carbon atoms, provided that 60% or more of the groups represented by R are preferably methyl groups.

The useful silicone rubbers for the invention are those obtained by the condensation reaction between the above silicone-based polymers and the following silicone crosslinking agents:

(1) R-Si(̵OR')

(2) R-Si(̵OAc)

(3) R-Si(̵ON=CR'₂)₂

wherein R is as defined above; R' is an alkyl group such as methyl, ethyl, etc.; and Ac is an acetyl group.

These silicone rubbers are commercially available ones such as 'YS-3085', produced by Toshiba Silicone Co.

Other useful silicone rubbers can be obtained by the reaction of the above base polymers with the following unit-having H-type silicone oil; the addition reaction of the above base polymers with silicone-based polymers in which 3% of the number of the groups represented by R are vinyl groups; or the reaction of the H-type silicone oil compounds with each other. 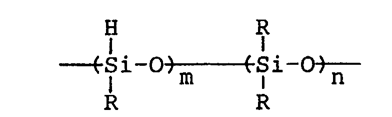 wherein R is as defined above; m is an integer of 2 or more; and n is an integer of 0, 1 or more.

The above crosslinking reaction for producing silicone rubbers requires a catalyst including organic carboxylic acid salts of metals such as tin, zinc, cobalt, lead, calcium, manganese, etc.; for example, dibutyl-tin laurate, tin (II) octoate, cobalt naphthenate, chloroplatinic acid, and the like.

The strength of the silicone rubber can be improved by mixing a filler therewith. Filler-premixed silicone rubbers are commercially available in the product names of silicone rubber stock and silicone rubber dispersion. If it is preferable to obtain a silicone rubber antislip layer by a coating method, a dispersion of RTV or LTV silicone rubber may be favorably used. Examples of this include silicone rubber dispersion products for paper coating use such as Syl Off 23, SRX-257 and SH 237, produced by Toray Silicone Co.

A polyester film provided thereon a silicone rubber layer, for example, 'Biotech' produced by Fuji Systems Co. is preferably used.

The silicone rubber layer preferably contains a silane coupling agent in order to improve the adhesiveness thereof to the support.

Examples of the silane coupling agent include:
(a)H₂NCH₂CH₂NHCCH₂CH₂CH₂Si(CH₃)₃
(b) 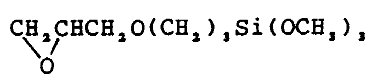
(c) HS(CH₂)₃Si(OCH₃)₃
(d) CH₂=CHSi(OCOCH₃)₃
(e) 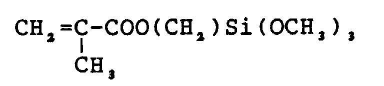
(f) CH₂=CHSi(OCH₂CH₃)₃
(g) H₂NCH₂CH₂NH(CH₂)₃Si(OCH₃)₂(CH₃)
(h) Chlorosilane

The antislip layer of the invention contains 40 to 100% by weight of the silicone rubber, and more preferably 70 to 100% by weight of the silicone rubber.

As the synthetic rubber there are styrene-butadiene rubber, butadiene rubber, isoprene rubber, chloroprene rubber, urethane rubber, polysulfide rubber, tetrafluoroethylene-propylene rubber, acryl rubber, epichlorohydrin rubber, ethylene-vinyl acetate rubber, 1,2-polybutadiene rubber; thermoplastic elastomers such as those of styrene type, olefin type, urethane type, polyester type, polyamide type and fluoro type; ethylene-propylene copolymer, ethylene-propylene-diene copolymer, nitrile-butadiene rubber, butyl rubber, fluororubber, chlorosulfonated polyethylene, propylene-oxide rubber, ethylene-acryl rubber, norbornane rubber and silicone rubber. Particularly, silicone rubber is suitably used. These rubbers may be used in combination.

To the antislip layer may be added an antideterioration agent, stabilizer, filling agent, coloring agent.

The image sheet 1B is superposed on the image-receiving paper 8 so that they are in close contact with each other with no air allowed therebetween. Even if a slight amount of air remains temporarily in the recesses of the fine rough surface of the image-receiving paper 8, the air is squeezed by the pressing force of the roller 42 toward the upstream side between the image-receiving paper 8 and the image sheet 1B, so that no air is present between them. The image-receiving paper 8, since its entire area is carried beforehand on the drum 12, does not become creased. Thus, the respective colors' patterns of an image 7 are certainly transferred onto the image-receiving paper 8, whereby a transferred color image closely resembled to an original image is formed.

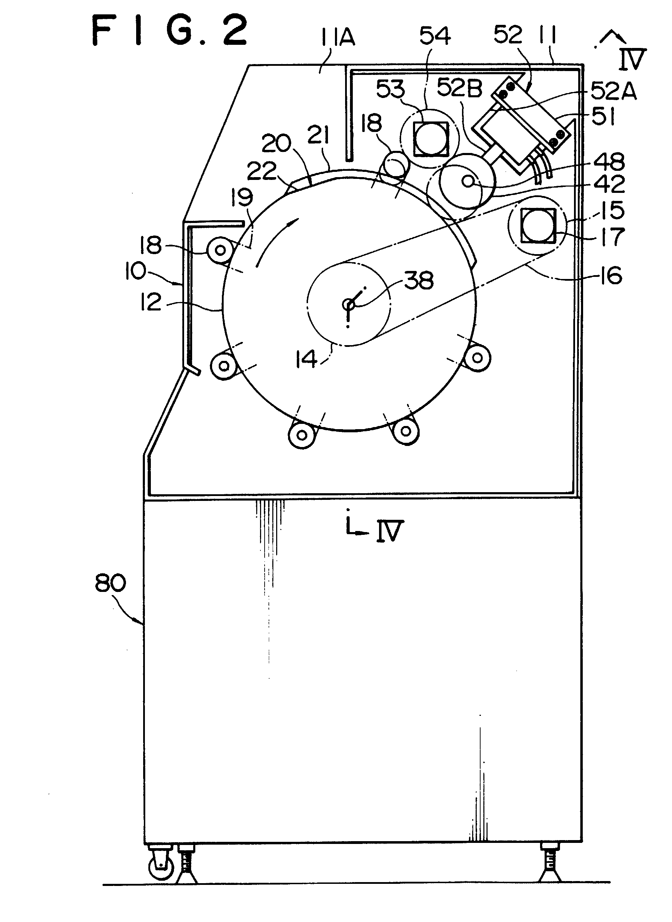

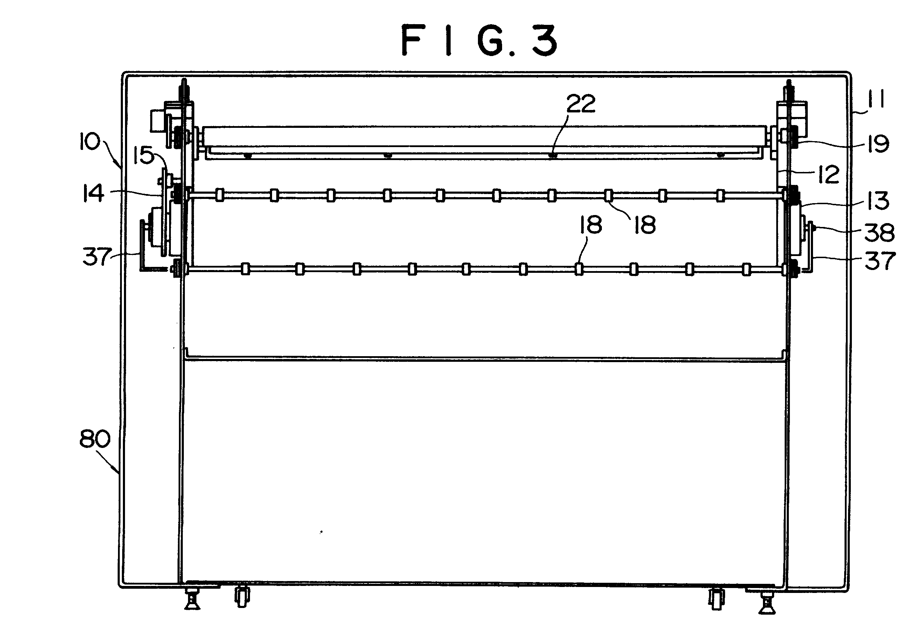

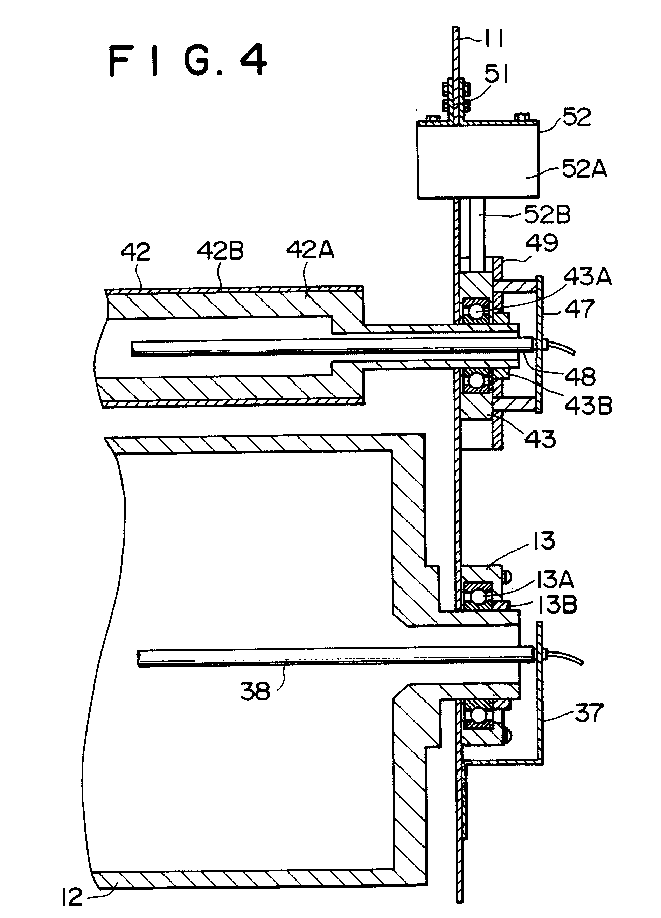

Fig. 2 is a front view of the internal construction of a transfer apparatus. Fig. 3 is a left side view of the same. Fig. 4 is a cross-sectional view as seen in the direction of arrows from the line IV-IV of Fig. 2. The transfer apparatus 10 is an integral part of and provided on a housing 80 having an air compressor (not shown) built-in.

An image transfer drum 12 is provided through a bearing 13 having built-in ball bearing 13A and bearing stopper 13B fixed to the body frame 11, wherein the drum 12 can be driven in the direction of arrow by a driving motor 17 through chain wheels 14 and 15 and chain 16. Also, in the axis a heater 38 is provided being held by a fixture 37. The drum 12 is so constructed as to make its entire temperature uniformly controllable (50 to 100°C) by the heater 38. On the periphery of the drum 12 are arranged a plurality of hold-down rollers 18 at given intervals, and the bearings of the hold-down rollers are provided to be so slidable in the radial direction of drum 12 at the body frame 11 by roller pressure spring 19 as to come into contact with the drum 12. The compression spring 19 is resiliently biased to move the foregoing bearings in the pressing direction. Pull-up spacers 21 are provided on both sides of the periphery of the drum 12 to make it possible to break the contact between the hold-down rollers 18 and the drum 12, resisting the compression spring 19.

A pressure roller 42 comprising an iron axis roller 42A covered with silicone rubber 42B is provided to press the uniformly heated transfer drum 12 and is capable of heating the drum to a required temperature, and the bearing sections at both ends thereof are supported by bearing 43 having built-in ball bearing 43A and bearing stopper 43B. The bearing 43 is mounted so as to slide through a slide guide 49 that is fixed to the body frame 11, and the sliding is made in the radial direction of the transfer drum. The bearing 43 is directly combined with the movable section 52B of a pressure air cylinder 52 connected to the air compressor in the housing 80, and the fixed section 52A of the pressure air cylinder 52 is fixed by a fixture 51 to the body frame 11. A heater 48 is stationarily provided on the axis of the foregoing heating press roller 42 and is fixed to a fixture 47 provided on the slidable bearing 43.

Procedure of locating an image-receiving paper and an image sheet (not shown) is as follows: The drum 12's surface section corresponding to the front end of the pull-up spacer 21 is designed to be flat as a location section 20, to which is mounted a pin bar 22. The small-diameter punched holes are provided at a side margin of an image sheet so as to be engaged with the pin bar 22 and wound around the copying sheet on the drum 12, so that the positional relation between the image-receiving paper and the image sheet can be precisely registered.

The image-receiving paper and image sheet are pressured to be in close contact with each other by and between the press roller 42 and the drum 12 by the action of the air cylinder 52; after that the image sheet is peeled apart from the image-receiving paper; and thus the image on the image sheet is transferred onto the image-receiving paper.

An armor cover 11A is provided outside the body frame 11 of the thus constructed transfer section 10 and housing 80, and on the armor cover is arranged a control panel and the like to facilitate and simplify the operation of the apparatus and also to insure safety.

When the location section 20 comes to its original position, the subsequent color transfer is carried out. Thus, only a transferred image composed of BK, Y, M and C colors is formed on the image-receiving paper, whereby a full color image is formed on the image-receiving paper, whereby a full color image reproduced as true as the original is obtained.

Next, experiments that were made to examine the quality of transferred images are explained.

### Experiment Example 1

Image sheets were prepared by using the following color image-forming materials and the following developer solution.

A releasing layer-forming solution of the following compositions was coated by using a wire bar on a 75µm-thick biaxially stretched polyethylene terephthalate film and then dried so as to make its dry thickness 0.5µm.

| | |
|---|---|
| Hydroxypropylmethylcellulose phthalate HP-55 produced by Shin-etsu Chemical Industry Co. | 5 g |
| Methyl cellosolve | 100 g |

Then, a thermally adhesive layer-forming solution having the following composition was coated on the releasing layer and then dried so as to make its dry thickness 7µm.

| | |
|---|---|
| Styrene/n-butyl acrylate copolymer (copolymerization molar ratio - 8/2, weight average molecular weight = 20,000) | 20 g |
| Methylethyl ketone | 100 g |

On this thermally adhesive layer was coated each of dispersions having the following compositions for forming colored light-sensitive layers and then dried so as to make its dry thickness 1.5µm, whereby colored light-sensitive films containing separately four different color pigments were prepared.

| | |
|---|---|
| 2,3,4-trihydroxybenzophenone-naphthoquinone-1,2-diazido-4-sulfonate | 0.616g |
| Vinyl acetate/vinyl versatate copolymer (80:20wt%, weight average molecular weight = 50,000, 50% methanol solution) | 8.768g |

The following pigments

| | |
|---|---|
| Cyclohexanone | 35.2 g |
| Fluorosurfactant (FC-430, produced by 3M) | 0.01g |

| Pigments: | | |
|---|---|---|
| Black | Carbon black MA-100, produced by Mitsubishi Chemical Industry Co. | 0.99g |
| Cyan | Cyanine blue 4920, produced by Dainichiseika Co. | 0.55g |
| Magenta | Seikafast carmine 1483, produced by Dainichiseika Co. | 0.68g |
| Yellow | Seikafast yellow 2400, produced by Dainichiseika Co. | 0.68g |

Each respective color separation screen positive film was separately superposed on the polyethylene terephthalate film support side of each of the light-sensitive films obtained above for forming four different color patterns of an image, and the light-sensitive film was exposed for 20 seconds through the screen film to a 4KW metal halide lamp at a distance of 50cm therefrom. The exposed light-sensitive film was developed by being immersed for 30 seconds in the following developer solution at 30°C, whereby four different color patterns' image sheets were prepared.

| Developer solution | |
|---|---|
| KONICA PS Plate Developer SDR-1, produced by KONICA Corporation | 20 ml |
| Pelex NBL, produced by Kawo Atlas Co. | 50 ml |
| Distilled water | 400 ml |

A drum 12 made of aluminum covered with Biotech*, produced by Fuji Systems Co., and a press roller 42 made of silicone rubber were heated to 80°C by their built-in infrared heaters 38 and 48, respectively. An art paper was wound around the silicone rubber layer 12, and on the paper was superposed the image sheet, and then the rotation of the drum 12 was started to conduct image transfer under pressure of 4kg/cm² by the press roller 42. The time required for the image transfer was 1 minute. After that, the film support of the image sheet was peeled off from the image-receiving paper (art paper). The peeling was easily made at the interface between the ethylene-vinyl acetate copolymer and the support film. The transfer operations were conducted in the order of BK, C, M and Y to form a color proof image consisting of the four colors on the art paper. The obtained color proof image showed that the respective image patterns of the image sheets were certainly transferred onto the art paper to form a high-quality image which is closely resembled to the varnished original image of an ordinary offset print.
*Biotech is a sheet in which a 50µm-thick silicone rubber layer is provided on a 100µm-thick polyethylene-terephthalate sheet.

### Experimental Example 2

Image sheets were prepared by using the following color-forming light-sensitive films (with no thermally adhesive layer) and the following developer solution.

Each of dispersions for forming colored light-sensitive layers having the following compositions was coated by using a wire bar and then dried so as to make its dry thickness 1.5µm on the ethylene-vinyl acetate copolymer resin layer surface of a 75µm-thick polyethylene terephthalate support on which was formed a 30µm-thick ethylene-vinyl acetate copolymer resin EVAFLEX P-1907 (produced by Mitsui-DuPont Polychemical Corp., vinyl acetate content 19% by weight, VICAT softening point 59°C) by an extrusion laminating method, whereby four different color image forming materials were prepared.

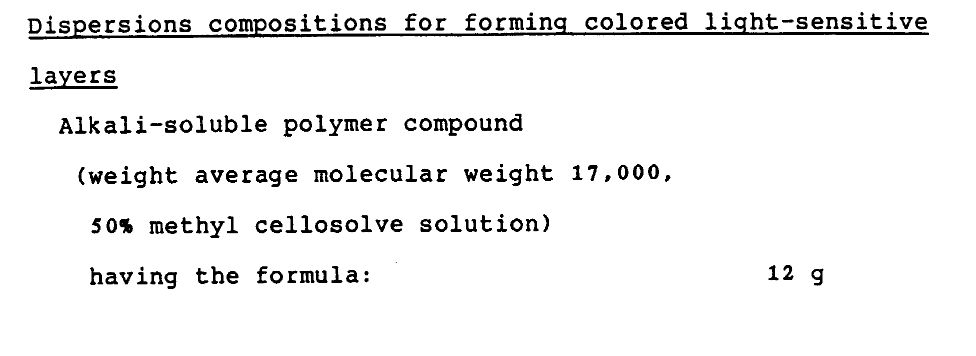

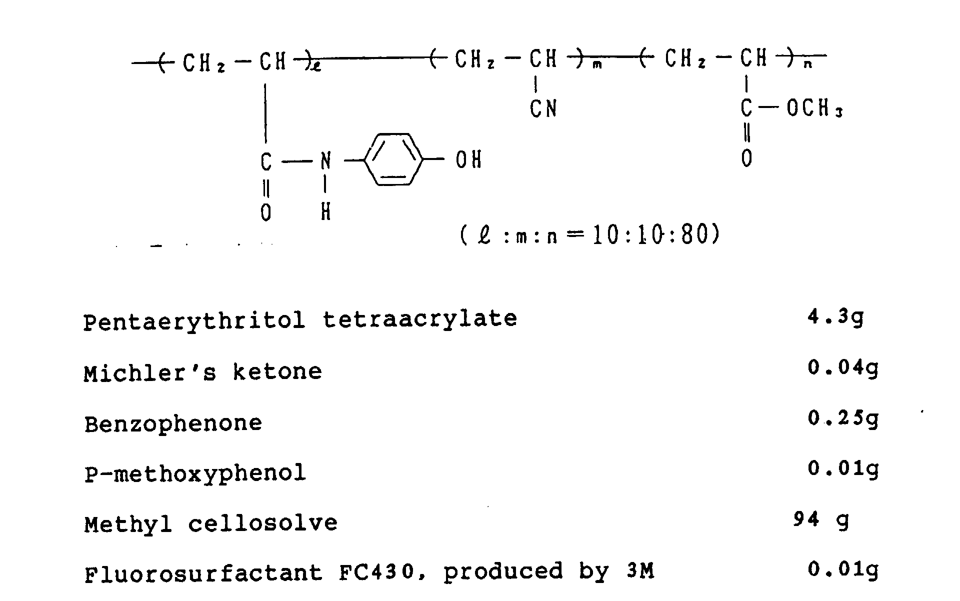

The following pigments

| Pigments | | |
|---|---|---|
| Black | carbon black MA-10, produced by Mitsubishi Chemical Industry Co. | 1.98g |
| Cyan | Cyanine blue 4920, produced by Dainichiseika Co. | 1.10g |
| Magenta | Seikafast carmine 1483, produced by Dainichiseika Co. | 1.36g |
| Yellow | Seikafast yellow 2400, produced by Dainichiseika Co. | 1.36g |

The alkali-soluble high polymer compound was synthesized by the following method.

In a one-liter 4-neck flask, 8.85 g of hydroxyphenylmeth-acrylamide, 2.65g g of acrylonitrile, 33.11g g of methyl acrylate and 1.64g of azobisisobutyronitrile (polymerization initiator) were put together with 200g of ethyl alcohol as a solvent, and the reaction of them took place at 77°C for 6 hours. After that, 75 g of methyl cellosolve were added thereto to stop the reaction, and the ethyl alcohol was distilled off for 3 hours at 60°C, whereby about 95g of a 50% methyl cellosolve solution of the above high polymer compound were obtained.

Next, on each color light-sensitive layer was coated by using a wire bar a solution for forming an overcoat layer having the following composition and then dried so as to make its dry thickness 0.3 µm, whereby four different color image-forming materials were prepared.

| Solution composition for forming overcoat layer | |
|---|---|
| Poly(vinyl alcohol) GL-05, produced by Nippon Synthetic Chemical Industry Co. | 6 g |
| Distilled water | 97 g |
| Methanol | 3 g |

A respective color separation screen negative film was superposed on the above color image-forming material obtained above, and the color image-forming material was exposed through the screen film for 20 seconds to a 4KW metal halide lamp light at a distance of 50 cm therefrom, and then developed by being immersed for 30 seconds in the following developer solution, whereby four different color patterns of an image were formed.

| Developer | |
|---|---|
| Sodium carbonate | 15 g |
| Surfactant Pelex NBL, produced by Kawo Atlas | 50 g |
| Distilled water | 1000 g |

Others were performed in the same manner as in Experimental Example 1.

The support film was peeled off together with the releasing layer, so that an image alone remained on the art paper, and the image of the image sheet was certainly transferred onto the art paper. As a result, a non-glossy color proof image closely resembling the non-glossy original image was obtained. The transferred image quality was excellent with no color doubling.

In the above example, heating and pressure are applied in combination to perform the transfer operation. However, pressure alone may be applied. In this instance, the heaters 38 and 48 in Figs. 1, 2 and 4 may be excluded. In the transfer by pressure alone, the image sheet used may be basically the same as that in the above transfer by heating and pressure, but the binder (polymer compound) contained in its light-sensitive composition has preferably a softening point of not higher than 60°C. In order to improve the transferrability by pressure, it is preferable that to the light-sensitive composition be added an adhesiveness donator such as petroleum resin, liquid butadiene, long-chain alkylphenol resin, etc., to an extent not to affect the image formation.

The examples of the present invention have been described, but on the basis of the idea of the invention, the above examples may be variously altered. For example, the image formed, aside from being a full color image of four colors, may be a monocolor or bicolor image, and the image formation in the invention may also be applied to small-quantity production of images except for color proof making. Also, the cylindrical drum 12 may be replaced by a different rotary body in a discretionary form such as an oval or regular polygon for the image transfer, or the transfer may be carried out on an endless belt as a running-around pressure-receiving body.

## Claims

1. A method for transferring an image from an image transfer medium onto an image receiving member, comprising:
exposing imagewise a coloured light-sensitive material comprising a transparent support and provided thereon a coloured light-sensitive layer;
developing the exposed material to obtain an image transfer medium having an image;
setting an image receiving member on an antislip silicone rubber layer provided on a rotatable sheet carrying member;
superposing the image transfer medium on the image receiving member; and
pressing the image transfer medium and the image receiving member onto the antislip silicone rubber layer provided on the sheet carrying member by a pressing member while rotating the sheet carrying member.

2. A method according to claim 1, which further comprises heating the image transfer medium.

3. A method according to claim 1 or 2, which further comprises heating the image transfer medium and the image receiving member.

4. A method according to claims 2 or 3, wherein the heating is conducted during the process of pressing.

5. An apparatus for transferring an image from an image transfer medium, in which an image to be transferred is formed by exposing imagewise a coloured light-sensitive material comprising a transparent support and provided thereon a coloured light-sensitive layer and developing the exposed material, to an image receiving member, comprising:
a rotatable sheet carrying member and, provided thereon, an antislip silicone rubber layer for loading an image transfer medium and an image receiving member thereon; and
a means for pressing the image transfer medium and the image receiving member onto the antislip silicone rubber layer provided on the sheet carrying member.

6. An apparatus according to claim 5, which further comprises a heating member for heating the image transfer medium.

7. An apparatus according to claims 5 or 6, wherein the pressing means is a pressing roller and the heating means is incorporated in the pressing roller.

8. An apparatus according to any of claims 5 to 7, which further comprises a means for peeling the support member from the sheet carrying member.

## Patentansprüche

1. Verfahren zum Übertragen eines Bildes von einem Bildübertragungsmedium auf ein Bildempfangsteil durch bildgerechtes Belichten eines farbigen lichtempfindlichen Aufzeichnungsmaterials mit einem durchsichtigen Schichtträger und einer darauf befindlichen farbigen lichtempfindlichen Schicht, Entwickeln des belichteten Aufzeichnungsmaterials zur Herstellung eines ein Bild aufweisenden Bildübertragungsmediums, Aufsetzen eines Bildempfangsteils auf eine auf einem drehbaren Folienträgerteil vorgesehene Siliconkautschuk-Antigleitschicht, Darauflegen des Bildübertragungsmediums auf das Bildempfangsteil und Aufpressen des Bildübertragungsmediums und des Bildempfangsteils auf die auf dem Folienträgerteil vorgesehene Siliconkautschuk-Antigleitschichtmittels eines Preßteils unter Drehen des Folienträgerteils.

2. Verfahren nach Anspruch 1, bei welchem ferner das Bildübertragungsmedium erwärmt wird.

3. Verfahren nach Anspruch 1 oder 2, bei welchem ferner das Bildübertragungsmedium und das Bildempfangsteil erwärmt werden.

4. Verfahren nach Ansprüchen 2 oder 3, bei welchem das Erwärmen während des Preßvorgangs erfolgt.

5. Vorrichtung zur Übertragung eines Bildes von einem Bildübertragungsmedium, auf welchem ein zu übertragendes Bild durch bildgerechtes Belichten eines farbigen lichtempfindlichen Aufzeichnungsmaterials mit einem durchsichtigen Schichtträger und einer darauf vorgesehenen farbigen lichtempfindlichen Schicht und Entwickeln des belichteten Aufzeichnungsmaterials gebildet werden, auf ein Bildempfangsteil, umfassend ein drehbares Folienträgerteil und eine darauf vorgesehene Siliconkautschuk-Antigleitschicht zum Auflegen eines Bildübertragungsmediums und eines Bildempfangsteils und eine Einrichtung zum Anpressen des Bildübertragungsmediums und des Bildempfangsteils an die auf dem Folienträgerteil vorgesehene Siliconkautschuk-Antigleitschicht.

6. Vorrichtung nach Anspruch 5, welche ferner eine Heizeinrichtung zum Erwärmen des Bildübertragungsmediums umfaßt.

7. Vorrichtung nach Ansprüchen 5 oder 6, bei welcher die Anpreßeinrichtung aus einer Preßwalze besteht und die Heizeinrichtung in die Preßwalze eingebaut ist.

8. Vorrichtung nach einem der Ansprüche 5 bis 7, welche ferner eine Einrichtung zum Abziehen des Schichtträgerteils vom Folienträgerteil umfaßt.

## Revendications

1. Procédé pour transférer une image d'un support de transfert d'image à un élément de réception d'image, comprenant :
l'exposition du point de vue d'une image d'un matériau coloré photosensible comprenant un support transparent et comportant sur celui-ci une couche colorée photosensible ;
le développement du matériau exposé de façon à obtenir un support de transfert d'image comportant une image ;
la disposition d'un élément de réception d'image sur une couche de caoutchouc aux silicones antidérapante disposée sur un élément de support de feuille rotatif ;
la superposition du support de transfert d'image sur l'élément de réception d'image ; et
le pressage du support de transfert d'image et de l'élément de réception d'image sur la couche de caoutchouc aux silicones antidérapante disposée sur l'élément de support de feuille par un élément de pressage tout en faisant tourner l'élément de support de feuille.

2. Procédé selon la revendication 1, qui comprend de plus le chauffage du support de transfert d'image.

3. Procédé selon la revendication 1 ou 2, qui comprend de plus le chauffage du support de transfert d'image et de l'élément de réception d'image.

4. Procédé selon la revendication 2 ou 3, dans lequel le chauffage est effectué durant le processus de pressage.

5. Dispositif pour transférer une image, à partir d'un support de transfert d'image, dans lequel une image devant être transférée est formée en exposant du point de vue d'une image un matériau coloré photosensible comprenant un support transparent, et comportant sur celui-ci une couche colorée photosensible, et en développant le matériau exposé, à un élément de réception d'image, comprenant :
un élément de support de feuille rotatif, et, disposée sur celui-ci, une couche de caoutchouc aux silicones antidérapante pour charger un support de transfert d'image et un élément de réception d'image sur celui-ci ; et
des moyens pour presser le support de transfert d'image et l'élément de réception d'image sur la couche de caoutchouc aux silicones antidérapante disposée sur l'élément de support de feuille.

6. Dispositif selon la revendication 5, qui comprend de plus un élément de chauffage pour chauffer le support de transfert d'image.

7. Dispositif selon la revendication 5 ou 6, dans lequel les moyens de pressage sont un rouleau de pressage, et les moyens de chauffage sont incorporés dans le rouleau de pressage.

8. Dispositif selon l'une quelconque des revendications 5 à 7, qui comprend de plus des moyens pour peler l'élément de support depuis l'élément de support de feuille.
